# EUROPEAN PATENT APPLICATION

(11) **EP 3 222 580 A1**
(43) Date of publication of application: **27.09.2017**
(21) Application number: 16461512.2
(22) Date of filing: 21.03.2016
(51) Int. Cl.: C01B 32/00

(54) **METHOD FOR PASSIVATING GRAPHENE**

(71) Applicant: Instytut Technologii Materialów Elektronicznych, 01-919 Warszawa (PL)
(72) Inventor: Ciuk, Tymoteusz, 03-159 Warszawa (PL); Strupinski, Wlodzimierz, 01-934 Warszawa (PL)
(74) Representative: Dobrzanski, Jan Pawel

(57) **Abstract**

The present invention relates to a method for passivating graphene in a graphene-based device, wherein graphene layer is deposited on a dielectric support, the method comprising pre-heating the graphene-based device under vacuum conditions, followed by covering graphene surface with a silicone layer. The invention also relates to a graphene-based device containing at least one graphene surface passivated by a silicone layer. The passivated graphene-based devices show stabilised graphene's electrical properties in electronic devices such as charge carrier concentration and charge carrier mobility.

## Description

### Technical Field

The present invention relates to a method for passivating graphene in a graphene-based device, wherein graphene layer is deposited on a dielectric support, the method comprising pre-heating the graphene-based device under vacuum conditions, followed by covering graphene surface with a silicone layer. The invention also relates to a graphene-based device containing at least one graphene surface passivated by a silicone layer.

### Background of the Invention

Graphene has been suggested an active layer in electronic devices due to its two-dimensional form, low carrier concentration and high carrier mobility. Unfortunately, unpassivated graphene adsorbs various molecules when exposed to ambient atmosphere. These molecules increase charge carrier concentration in graphene and decrease its charge carrier mobility, greatly affecting graphene's electrical properties and device's operating point. The sensitivity of graphene-based devices to surface adsorbates requires proper graphene passivation in order to operate them under ambient conditions.

Among many technologies of graphene synthesis, two are preferable for mass production of graphene-based devices. These are: deposition of graphene by vapor phase epitaxy on a substrate comprising a surface of silicon carbide (EP 2392547 (A2)), and heating of a carbide crystal for a sufficient time so that at least one non-carbon element evaporates from the crystal face of the carbide crystal to form a graphitic layer (US 2009226638 (A1)). Most commonly hexagonal polytypes (4H and 6H) of silicon carbide are selected as a target substrate.

In both technologies mentioned above, the as-grown charge carrier concentration in graphene is not random but results from the value of spontaneous polarization of hexagonal SiC. The surface of SiC, as of any polarized dielectric, is decorated with excess surface bound charge originating from the ends of dipoles that cannot be compensated by oppositely charged ends of the neighboring dipoles. As a result, the spontaneous polarization of SiC is an intrinsic feature of all its hexagonal polytypes. The bulk spontaneous polarization values correspond to an associated bound surface charge density and a sheet of positive charge induced in any quasi-free-standing graphene on silicon carbide. Depending on the silicon carbide polytype the as-grown doping level in graphene is different but well defined.

Details on the as-grown doping level in graphene on silicon carbide (4H and 6H) were described in the following publications:
[1] Ciuk, T., Strupinski, W., "Statistics of epitaxial graphene for Hall effect sensors", Carbon 93, 1042-1049 (2015).
[2] Ciuk, T., Caban, P., Strupinski, W., "Charge carrier concentration and offset voltage in quasi-free-standing monolayer chemical vapor deposition graphene on SiC", Carbon 101, 431-438 (2016).

These publications describe studies including inter alia measurement of as-grown charge carrier concentration and charge carrier mobility in hundreds of quasi-free-standing bilayer and quasi-free-standing monolayer graphene samples on silicon carbide. One of the resulting findings is that the more optimum the growth conditions and the higher the obtained charge carrier mobility, the closer the charge carrier concentration to a specific value being consistent with the adopted explanation for the origin of the as-grown doping level in epitaxial graphene based on the spontaneous polarization of hexagonal SiC.

This knowledge helps design and predict the properties of graphene-based devices. However, when exposed to ambient conditions these initial as-grown electrical properties gradually change as graphene adsorbs molecules from the atmosphere. Studies have shown that the charge concentration gradually increased and the charge carrier mobility gradually decreased over time.

### Summary of the invention

The aim of the present invention was to stabilise graphene's electrical properties in electronic devices such as in particular charge carrier concentration, charge carrier mobility and resultant sheet resistance, so as to allow to use these devices in a reliable manner in ambient conditions. As a result of the study carried out by the inventors it has been found that coating graphene surface of graphene-containing device, pre-heated under vacuum conditions, with a silicone layer allows to greatly reduce the change of these electrical parameters of such device over time.

Accordingly, the present invention relates to a method for passivating graphene in a graphene-based device, wherein graphene layer is deposited on a dielectric support, the method comprising pre-heating the graphene-based device under vacuum conditions, followed by covering graphene surface with a silicone layer.In one preferred embodiment of the method according to the invention the dielectric support is made of silicon carbide.

In another preferred embodiment of the method according to the invention the graphene layer is formed of epitaxial graphene. More preferably, the graphene layer is obtained by chemical vapor deposition (CVD) method. In another preferred variant, the graphene layer is obtained by graphitization of silicon carbide surface through sublimation of silicon atoms.

In a further preferred embodiment of the method according to the invention the silicon carbide support is selected from hexagonal polytypes 4H-SiC and 6H-SiC, such as 4H-SiC (0001) and 6H-SiC (0001).

In yet another preferred embodiment of the method according to the invention the silicone layer is formed of a solvent-free silicone. More preferably, the silicone is selected from silicone encapsulants showing at least one of the following parameters:
volume resistivity above 5 x 10¹³ Ω·cm,
volumetric thermal expansion coefficient less than 837 ppm/°C,
linear thermal expansion coefficient less than 279 ppm/°C,
dielectric strength above 17.5 kV/mm.

Preferred silicone encapsulants suitable for being used in the method according to the invention include products commercially available from ACC Silicones Ltd., Bridgewater, UK, such asoptically clear 2-part encapsulants QLE1102, QSiI216 and QSiI222, transparent 2-part encapsulate QSiI12, transparent 2-part liquid silicone rubbers QSiI218 and QSiI229, 2-part flame retardant encapsulant QSiI430, 2-part addition cure encapsulants QSiI550 and QSiI556, 2-part thermally conductive silicone encapsulants QSiI553 and SE2003, 2-part thermally conductive silicone elastomer QSiI573, 2-part silicone silicone encapsulant SE2005, 2-part flowable potting compound SE2008T, 2-part high temperature rubber Silcoset 101, and 2-part potting compound Silcoset 105.

In a further preferred embodiment of the method according to the invention duration of the pre-heating step is not less than 16 hours, and preferably is 24 h.

The pre-heating step is preferably carried out under vacuum conditions with pressure being 1 x 10⁻⁶ mbar and, also preferably, at the temperature of 150°C. Specific values of temperature and pressure at the pre-heating stage depend on the actual arrangement of the apparatus. The higher vacuum, the better, but in any case the vacuum level must be sufficient to allow gas desorption.

In a still further preferred embodiment of the method according to the invention the graphene surface is covered by the silicone layer by means of spray-coating, spin-coating or applying at least one silicone droplet onto surface to be coated and allowing a uniform layer to be formed.

In another preferred embodiment of the method according to the invention after the pre-heating step the graphene-based device is allowed to cool down under vacuum to room temperature before the silicone layer is applied thereon.

The invention also relates to a graphene-based device containing at least one graphene surface passivated by a silicone layer.

In a preferred embodiment the device according to the invention is obtained by the method according to the invention as described above.

### Brief description of drawings

The invention is illustrated by means of preferred embodiments with their features being evident in the drawings. In the drawings:
- Fig. 1: shows room-temperature Hall effect hole mobility and concentration in quasi-free-standing hydrogen-intercalated bilayer graphene obtained and investigated as described in [1];
- Fig. 2: shows room-temperature Hall effect hole mobility and concentration in quasi-free-standing hydrogen-intercalated monolayer graphene obtained and investigated as described in [2];
- Fig. 3: shows the temporal evolution of charge carrier concentration, charge carrier mobility and the resultant sheet resistance of graphene that had been subjected to high vacuum and elevated temperature and then exposed to ambient atmosphere;
- Fig. 4: shows the temporal evolution of charge carrier concentration, charge carrier mobility and the resultant sheet resistance of graphene that had been subjected to high vacuum and elevated temperature, passivated with a silicone layer and then exposed to ambient atmosphere.

### Detailed description of the invention

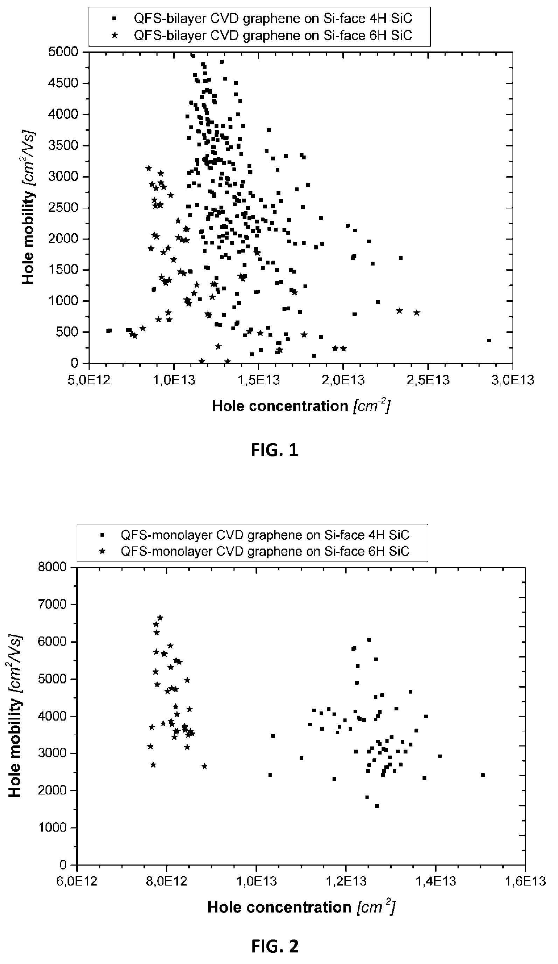

Figures 1 and 2 present a dataset of measured as-grown charge carrier concentration and charge carrier mobility in hundreds of quasi-free-standing bilayer and quasi-free-standing monolayer graphene samples on silicon carbide. The observable large spread in the data resulted from the accumulative experience in growth technology, but it is evident that the more optimum were the growth conditions and the higher was the obtained charge carrier mobility, the closer was the charge carrier concentration to a specific value that is consistent with the adopted explanation for the origin of the as-grown doping level in epitaxial graphene based on the spontaneous polarization of hexagonal SiC (n_{6H} = +7.5 x 10¹² cm⁻², n_{4H} = +1.2 x 10¹³ cm⁻²).

More specifically, fig. 1 shows room-temperature Hall effect hole mobility and concentration (as-grown) in quasi-free-standing hydrogen-intercalated bilayer graphene measured in van der Pauw geometry on 380 4H-SiC(0001) and 80 6H-SiC(0001) 10 mm x 10 mm samples grown in 460 individual epitaxial Chemical Vapor Deposition processes on semi-insulating on-axis Si-terminated substrates. Fig. 2 shows room-temperature Hall effect hole mobility and concentration (as-grown) in quasi-free-standing hydrogen-intercalated monolayer graphene measured in van der Pauw geometry on 70 4H-SiC(0001) and 40 6H-SiC(0001) 10 mm x 10 mm samples grown in 110 individual epitaxial Chemical Vapor Deposition processes on semi-insulating on-axis Si-terminated substrates.

### Comparative example

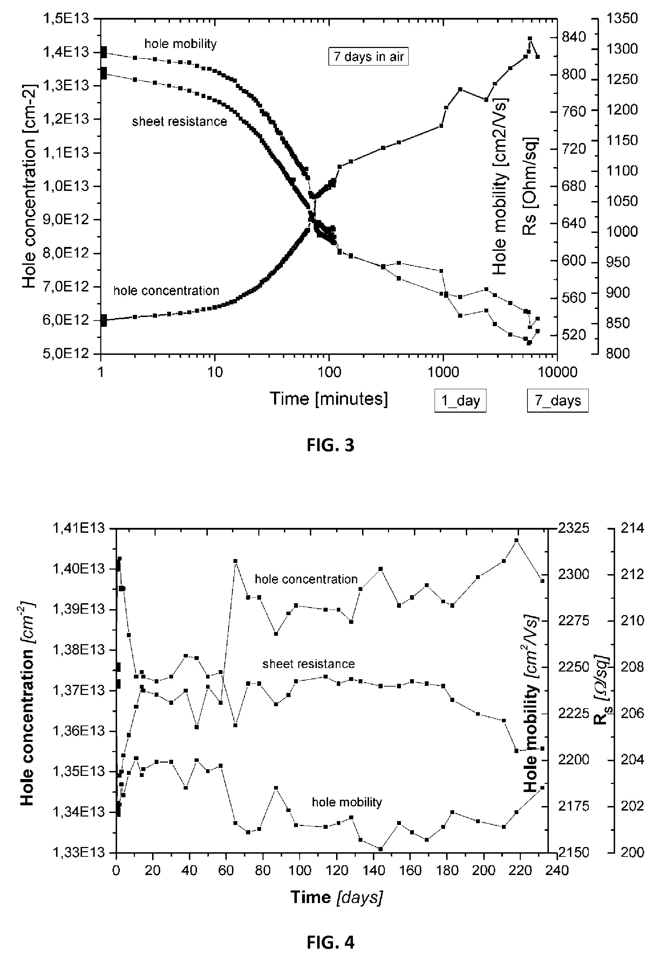

An epitaxial graphene sample on SiC support obtained in a CVD process was closed in a vacuum chamber at the pressure of 1 x 10⁻⁶ mbar and heated to 150°C for 24 hours. After the pre-heating step the graphene sample was allowed to cool down under vacuum to room temperature. Then the chamber was unsealed and the sample was removed. Further, it was exposed to ambient atmosphere (so as to be able to adsorb molecules from the air) and characterized over time. It has been observed that the charge concentration gradually increased and the charge carrier mobility gradually decreased. The results of the experiment are presented in fig. 3, showing the temporal evolution of charge carrier concentration, charge carrier mobility and the resultant sheet resistance of the graphene sample. The relative changes in the graphene sample's electrical parameters after 7 days were +133% for charge carrier concentration, -37% for charge carrier mobility and -34% for the resultant sheet resistance.

### Example 1

An epitaxial graphene sample on SiC support obtained in a CVD process was closed in a vacuum chamber at the pressure of 1 x 10⁻⁶ mbar and heated to 150°C for 24 hours. After the pre-heating step the graphene sample was allowed to cool down under vacuum to room temperature. Then the chamber was unsealed and the sample was removed. The sample was then coated with a silicone oil, namely 2-part addition cure encapsulant QSiI550 (from ACC Silicones Ltd., Bridgewater, UK), by applying a droplet of the silicone oil on the sample surface and allowing it to form a uniform layer over the entire surface. The resulting silicone layer was allowed to cure for 24 hours at room temperature. After that the sample was exposed to ambient atmosphere and characterized over time for 240 subsequent days. It has been observed that the presence of the silicone layer greatly stabilized graphene's electrical properties by protecting the graphene surface from the influence of the ambient atmosphere. The results of the experiment are presented in fig. 4, showing the temporal evolution of charge carrier concentration, charge carrier mobility and the resultant sheet resistance of the sample.

The relative changes in graphene's electrical parameters after 240 days were only +4% for charge carrier concentration, -1% for charge carrier mobility and -2% for the resultant sheet resistance.

## Claims

1. A method for passivating graphene in a graphene-based device, wherein graphene layer is deposited on a dielectric support, the method comprising pre-heating the graphene-based device under vacuum conditions, **characterised in that** graphene surface is covered with a silicone layer.

2. The method according to claim 1, wherein the dielectric support is made of silicon carbide.

3. The method according to claim 1 or 2, wherein the graphene layer is formed of epitaxial graphene.

4. The method according to claim 3, wherein the graphene layer is obtained by chemical vapor deposition (CVD) method.

5. The method according to claim 3, wherein the graphene layer is obtained by graphitization of silicon carbide surface through sublimation of silicon atoms.

6. The method according to any of the claims 2-5, wherein the silicon carbide support is selected from hexagonal polytypes 4H-SiC and 6H-SiC.

7. The method according to any of the claims 1-6, wherein the silicone layer is formed of a solvent-free silicone.

8. The method according to claim 7, wherein the silicone is selected from silicone encapsulants showing at least one of the following parameters:
volume resistivity above 5 x 10¹³ Ω·cm,
volumetric thermal expansion coefficient less than 837 ppm/°C,
linear thermal expansion coefficient less than 279 ppm/°C,
dielectric strength above 17.5 kV/mm.

9. The method according to any of the claims 1-8, wherein duration of the pre-heating step is not less than 16 hours, and preferably is 24 h.

10. The method according to any of the claims 1-9, wherein the pre-heating step is carried out under vacuum conditions with pressure being 1 x 10⁻⁶ mbar.

11. The method according to claims 1-10, wherein the pre-heating step is carried out at the temperature of 150°C.

12. The method according to any of the claims 1-11, wherein the graphene surface is covered by the silicone layer by means of spray-coating, spin-coating or applying at least one silicone droplet onto surface to be coated and allowing a uniform layer to be formed.

13. The method according to any of the claims 1-12, wherein after the pre-heating step the graphene-based device is allowed to cool down under vacuum to room temperature before the silicone layer is applied thereon.

14. A graphene-based device containing at least one graphene surface passivated by a silicone layer.

15. The device according to claim 14 obtained by the method defined in one of the claims 1-13.
